**Europäisches Patentamt**

**European Patent Office**

**Office européen des brevets**

(11) Publication number: **0 144 248**
**B1**

(12) **EUROPEAN PATENT SPECIFICATION**

(45) Date of publication of patent specification: **01.03.89**

(51) Int. Cl.⁴: **H 01 L 27/08,** H 01 L 21/324, H 01 L 29/06, H 01 L 21/82

(21) Application number: **84308517.6**

(22) Date of filing: **07.12.84**

(54) **Mis type semiconductor device element on a semiconductor substrate having a well region.**

(30) Priority: **07.12.83 JP 230862/83**

(43) Date of publication of application:
**12.06.85 Bulletin 85/24**

(45) Publication of the grant of the patent:
**01.03.89 Bulletin 89/09**

(84) Designated Contracting States:
**DE FR GB**

(56) References cited:
**DE-A-2 801 085**
**GB-A-1 153 428**

**PATENTS ABSTRACTS OF JAPAN, vol. 6, no. 259 (E-149)1137r, 17th December 1982; & JP - A - 57 155 777 (SHARP K.K.) 25-09-1982**
**IDEM**
**INTERNATIONAL ELECTRON DEVICES MEETING, 13th-15th December 1982, San Francisco, paper 29-3, pages 706-709, IEEE, New York, US; L.C. PARRILLO et al.: "Twin-tub CMOS II-an advanced VLSI technology"**

(73) Proprietor: **FUJITSU LIMITED**
**1015, Kamikodanaka Nakahara-ku**
**Kawasaki-shi Kanagawa 211 (JP)**

(72) Inventor: **Shirato, Takehide c/o Fujitsu Ltd.**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device and in particular it concerns a structure of a metal insulator semiconductor (MIS) type field effect transistor (FET) device element formed on a semiconductor substrate having a well region.

MIS type field effect transistor (FET) device elements, formed in semiconductor substrates having well regions, are employed for example in complementary metal oxide semiconductor (CMOS) IC's.

In the field of large scale integration (LSI) devices, CMOS technology is widely used. In order to improve the switching speed and the packing density which can be achieved with CMOS technology it has been proposed to reduce channel lengths.

In a previous CMOS IC, a p-type well region is formed in an n-type semiconductor substrate by introducing into a portion of the substrate an amount of a p-type impurity sufficient to compensate for the substrate n-type impurity. A p-channel type MOS FET (p-MOS FET) is formed on the n-type substrate, and an n-MOS FET is formed on the p-type well region. In order to increase switching speed and packing density of a CMOS device, it is effective to reduce FET channel length. An n-MOS FET formed on a p-type well region having a high concentration of impurity presents no special difficulty, but it is difficult to reduce the channel length of a p-MOS FET formed on the n-type substrate having a low concentration of impurity. One problem encountered is a MOS FET "punch-through" effect. The punch-through effect is occasionally caused on a substrate having a low concentration of impurity. When a voltage is applied across the electrodes on a source region and a drain region of a MOS FET formed on the substrate, depletion layers from these regions extend beneath the gate of the MOS FET to cause a punch-through current to flow between the source region and the drain region. As a result, a performance of the MOS FET is disturbed by the punch-through effect.

Previously, for MOS FET fabrication, in order to avoid this punch-through effect, a "twin-tub" structure has been proposed for use. The twin-tub structure has been proposed as suitable for reducing channel length of MOS FETs.

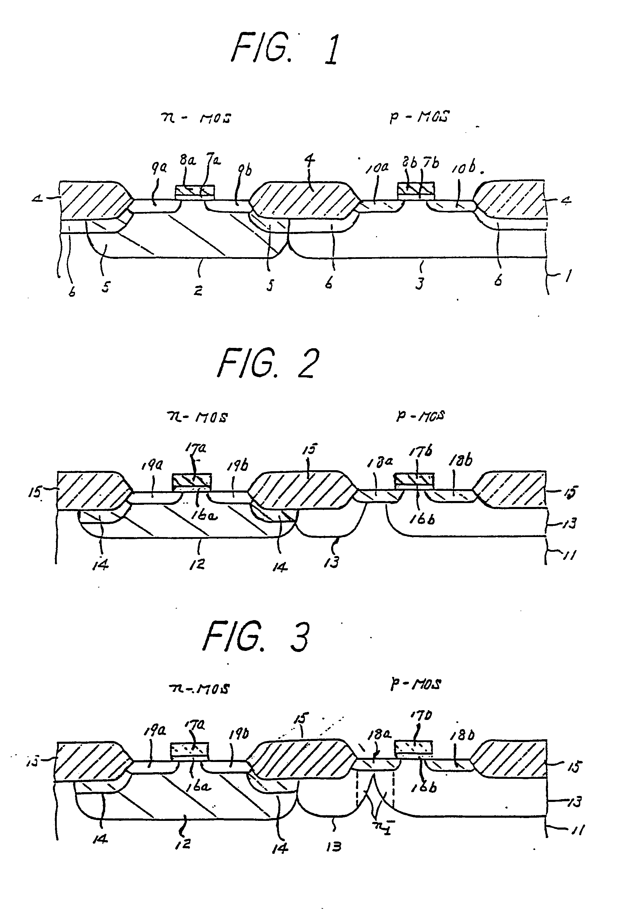

Figure 1 is a schematic cross-sectional view illustrating a previous twin-tub MOS FET structure. A well region 2 and another well region 3 are formed at the surface of a semiconductor substrate 1. The two well regions both have high impurity concentrations compared with the substrate but they respectively contain impurities of opposite conductivity types. An n-MOS FET and a p-MOS FET are formed on the well regions respectively. In Figure 1, 1 is an n-type silicon (Si) substrate, 2 is a p-type well region, 3 is an n-type well region, 4 is a field oxide film (isolation element), 5 is a $p^+$-type channel cut region, 6 is an $n^+$-type channel cut region, 7a and 7b are respective gate oxide films, 8a and 8b are respective gate electrodes, 9a is an $n^+$-type drain region, 9b is an $n^+$-type source region, 10a is a $p^+$-type drain region, 10b is a $p^+$-type source region, n-MOS designates an n-channel MOS FET, and p-MOS designates a p-channel MOS FET.

With the twin-tub structure of Fig. 1, one major drawback is that the junction capacitance between the $p^+$-type drain region 10a and the n-type well region 3 becomes large. The parasitic drain capacitance functions as a load in switching operations, and switching speed of the p-channel MOS FET is decreased. When a reverse-bias voltage is applied across the source region, the switching speed of the MOS FET is disturbed by the junction capacitance of the source region as well.

GB—A—1 153 428 discloses a semiconductor device in which $N^+$ regions are provided as source and drain regions in a P-type substrate. A zone contiguous with the $N^+$ drain region has a reduced concentration of P-type impurities to reduce the width of a depletion layer extending around the drain region when the device is in use, to provide lower output capacitance.

JP—A—57 155 777 discloses an MOS transistor in which, in a p-type substrate a p-type well is formed under the gate of the transistor. On source and drain sides of the well $\overline{P}$-type regions overlap the well. Under $n^+$-type source and drain regions, n-type regions are formed up to the well. This is intended to reduce drain/substrate and source/substrate capacitance.

According to the present invention there is provided a semiconductor device comprising a semiconductor device comprising a semiconductor substrate of one conductivity type generally with a relatively low impurity concentration, a well region, of the said one conductivity type, formed in the substrate, with a relatively high impurity concentration, and an MIS FET, of a channel conduction type opposite to the substrate conductivity type, formed on the well region, isolated by a field insulating layer, the well region extending under the field insulating layer to provide a channel cut function and extending beneath a gate of the MIS FET, characterised in that a part of at least the well region does not extend beneath at least the drain region of source and drain regions of the MIS FET.

An embodiment of the present invention can facilitate the reduction of channel length of an MIS FET (e.g. a MOS FET) device element formed on a semiconductor substrate having a well region.

An embodiment of the present invention can offer an improvement in switching speed of a semiconductor device.

An embodiment of the present invention can provide for simplification with regard to the provision of a channel-cut region in a semiconductor device.

An embodiment of the present invention is advantageously applicable to CMOS devices, for example for providing improved switching speed, e.g. by facilitating a reduction in channel length.

An embodiment of the present invention can, of course, be applied in contexts other than CMOS devices. For example, application to n-MIS IC's is possible.

An embodiment of the present invention can provide a semiconductor device having a high circuit element switching speed, by allowing improvement in relation to reduced channel length.

An embodiment of the present invention can provide a structure of MIS FET which can improve circuit element switching speed.

An embodiment of the present invention can provide for simplification in a fabrication method with regard to formation of a circuit element channel-cut region.

In an embodiment of the present invention there is selectively formed a well region having a high concentration of impurity of the same conductivity type as that of the semiconductor substrate in which it is formed. The well region, having the same conductivity type as, but a higher impurity concentration than, the substrate is selectively formed in regions where an MOS FET of a channel conduction type opposite to the substrate conductivity type is to be formed. However, the well region is not formed at least in a region under the drain region of the MOS FET.

As the well region has a high impurity concentration as compared with that of the substrate, occurrence of the punch-through effect between the source region and the drain region is prevented. Despite the high impurity concentration of the well region, since the junction area between the drain region of the MOS FET and the well region is reduced, the junction capacitance of the drain is reduced, and is for example smaller than that of a corresponding MOS FET (e.g. an MOS FET formed in a well region of high impurity concentration of the same conductivity type as the substrate, having a channel conduction type opposite to the substrate conductivity type) formed in the previously proposed twin-tub structure.

In an embodiment of this invention impurity concentration of the well region can advantageously be higher than that provided with the previously proposed twin-tub structure, and the well region can serve to fulfil a channel-cut function, in place of a channel-cut region as previously proposed. Thus, a channel-cut (well) region can be formed without any additional fabricating process being necessary for forming this highly doped region. One more advantage of the use of the well region for fulfilling a channel-cut function in place of a channel-cut region as previously proposed, which is relatively shallow, is that an improvement can be provided as regards the ability to prevent the occurrence of a latch-up phenomenon in a CMOS IC, which phenomenon can disturb normal operation. Low resistivity by the well region at bulk portion is effective to prevent the latch-up.

The employment of an embodiment of the present invention in relation to a CMOS IC allows channel length to be reduced in the CMOS IC. As a result, a CMOS IC can be provided with high speed and stable operation with very low power consumption.

Reference is made, by way of example, to the accompanying drawings, in which:—

Figure 1 is a schematic cross-sectional view illustrating a previously proposed MOS FET twin-tub structure,

Figure 2 is a schematic cross-sectional view illustrating a first embodiment of the present invention,

Figure 3 is a schematic cross-sectional view illustrating a second embodiment of the present invention, having a reduced structure as compared with Figure 2, in which the shape of a well region is modified by an annealing process,

Figure 4 is a schematic cross-sectional view illustrating a third embodiment of the present invention,

Figure 5 is a schematic cross-sectional view illustrating a fourth embodiment of the present invention, having a reduced structure as compared with Figure 4, in which the shape of a well region is modified by an annealing process, and

Figure 6 is a series (A to G) of schematic cross-sectional views illustrating steps in the fabrication of a semiconductor device in accordance with an embodiment of the present invention.

Figures 2 to 5 illustrate semiconductor device structures according to respective embodiments of the present invention as applied to MOS transistors in CMOS ICs in which the substrate is of $n^-$-type silicon. (It will be understood that the present invention can find application to different devices, different IC types and substrates of different conductivity types).

As compared with the structure of Figure 1, it might be said that in these embodiments of the present invention a part of the $p^+$-type drain region directly contacts the $n^-$-type silicon substrate region at a single junction.

In Figures 2 to 5, 11 is an $n^-$-type silicon (Si) substrate which has a doping concentration approximately in the vicinity of $5 \times 10^{14}$ (atm/cm$^3$), 12 is a p-type well region, which has a doping concentration approximately in the vicinity of $5 \times 10^{16}$ (atm/cm$^3$) and is 3 μm to 4 μm deep, 13 (13a, 13b) is an n-type well region formed under a field oxide film and a gate oxide film, which has a doping concentration approximately in the vicinity of $5 \times 10^{16}$ (atm/cm$^3$), and is 3 μm to 4 μm deep, 14 is a p-type channel cut region, 15 is a field oxide film (isolation layer), 16a and 16b are respective gate oxide films, 17a and 17b are respective polycrystalline silicon gate electrodes, 18a is a $p^+$-type drain region, 18b is a $p^+$-type source region, 19a is an $n^+$-type drain region, 19b is an $n^+$-type source region, and $n_1^-$ ($n_a^-$, $n_b^-$) is a region containing an impurity at a low concentration corresponding to the substrate 11, which has a specific profile of impurity concentration. The details of the $n_1^-$ ($n_a^-$, $n_b^-$) region will be described below with reference to Figure 3. n-MOS designates an n-channel MOS FET and p-MOS designates a p-channel MOS FET.

In the embodiment of Figure 2, the present invention is applied to the p-MOS FET in the n-type well 13 formed directly on the n⁻-type substrate 11. The well region 13 is selectively formed at regions under the gate electrode 17b, the p⁺-type source region 18b and the field insulating layer 15, but excluding a region under the p⁺-type drain region 18a (and the zone of the p-type well region 12). As the result, the junction capacitance of the p⁺-type drain region 18a is reduced. So, the switching speed of the device in the CMOS IC is improved.

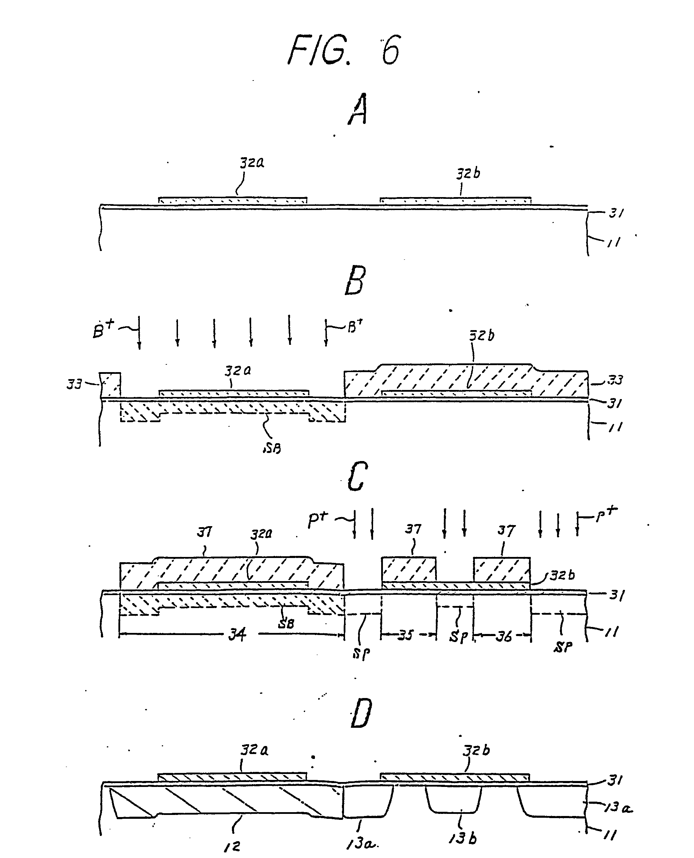

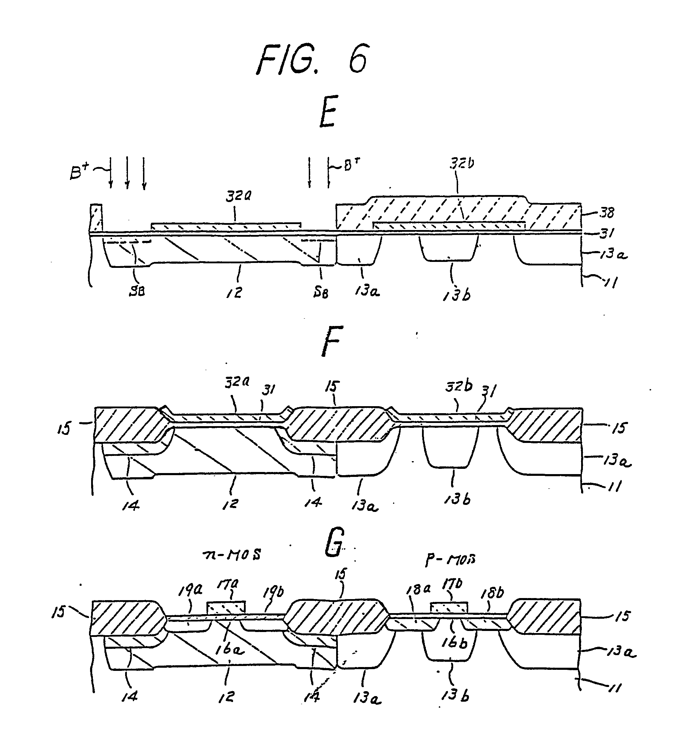

Figure 3 is a schematic cross-sectional view of a structure which is reduced or scaled down as compared with that of Figure 2 in which the shape of the well 13 is modified by an annealing process. Unlike the structure of Figure 2, the gap of the well 13 under p⁺-type drain region 18a is shown finely. As the scale of integration of the semiconductor device increases and the sizes of the drain region and source region are correspondingly scaled down, when a p-MOS FET of a CMOS IC is formed on an n-type well region 13 having a higher impurity concentration than that of the substrate 11, an $n_1^-$ region may be formed at the region under p⁺-type drain region 18a as a result of an annealing process: that is, a process for annealing the semiconductor substrate in order to diffuse and activate doping material for forming impurity regions such as source and drain regions. Details of such annealing process will be described below with reference to Figure 6D. In such an annealing process, since parts of well region 13 are diffused laterally, the $n_1^-$ region is formed at the region under p⁺-type drain region 18a by the annealing process. The $n_1^-$ region has a low concentration of impurity corresponding to the n⁻ type substrate, to form a p-n junction of a low impurity concentration with the drain region 18a. Thus, the drain-substrate capacitance associated with such a contact region $n_1^-$ is smaller than the capacitance of the previously proposed twin-tub CMOS FET structure. As a result, the switching speed of such device in a CMOS IC can be improved.

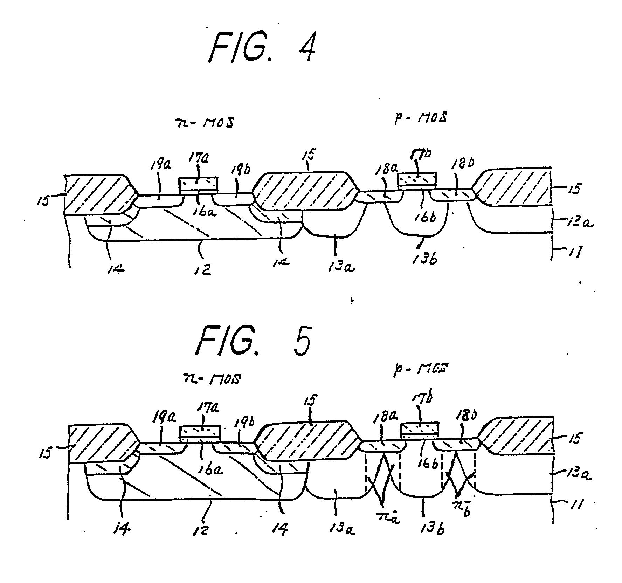

Figure 4 is a schematic cross-sectional view of a third embodiment of the present invention. This embodiment is advantageously applied especially to a device in which in use a bias potential is applied between the substrate and the source region 18b. In this embodiment of the present invention the n-type well region 13 (13a, 13b) is not formed under parts of both p⁺-type drain region 18a and the p⁺-type source region 18b. In particular, the drain region 18a and the source region 18b contact directly with the n⁻-type substrate 11 which has a low impurity concentration. Therefore, the junction capacitance of the source region 18b as well as drain region 18a becomes smaller. So, the switching speed of the device in the CMOS IC is improved.

Figure 5 is a schematic cross-sectional view of a structure which is reduced or scaled down as compared with the structure of Figure 4, in which the shape of the wells are modified by an annealing process. As the structure of Figure 4 is scaled down, similarly to the scaling down of the structure of Figure 3, when a p-MOS FET of a device in the CMOS IC is formed on the n-type well region 13a and 13b having impurity concentration higher than that of the substrate region 11, the n-type region 13a and 13b extends under the drain and source regions 18a and 18b by lateral diffusion from both sides of the latter regions, as a result of annealing. Nevertheless the device in accordance with an embodiment of the present embodiment has smaller parasitic junction capacitance characteristics owing to the low concentration impurity profile around the regions under source and drain regions 18a and 18b. As shown in Figure 5 new n⁻-type regions $n_a^-$ and $n_b^-$ are formed under the drain region 18a and the source region 18b by the annealing process. The n⁻-type regions $n_a^-$ and $n_b^-$ have low impurity concentrations corresponding to the substrate which has a specific profile of impurity concentration compared to that of n regions 13a and 13b, though at slightly higher concentrations as compared to the n⁻-type substrate. Therefore, the junction capacitance of the source and drain regions becomes smaller. So, the switching speed of the device in the CMOS IC is improved.

According to an embodiment of the present invention, as described above, an n-type well region 13 (13a, 13b) is formed under the gate electrode of a p-channel MOS FET, but omitted from beneath drain and/or source regions. The n-type well region is deeper than the source and the drain regions. The n-type well region 13 (13a, 13b) has a high impurity concentration as compared with the substrate. Therefore, a punch-through effect, which might otherwise be generated between the source region and the drain region (in correspondence to portion 13b in Figure 4 or Figure 5) is prevented.

This enables the channel length of the p-channel MOS FET to be reduced, as compared with that of the p-MOS FET of the previously proposed twin-tub structure for example, by increasing the impurity concentration so that the junction capacitance of the source and the drain is maintained at a constant level. As a result, a CMOS IC, for example, in which an embodiment of the present invention is applied can have superior characteristics of high speed and stable operation with very low power consumption.

As indicated above, a portion of the n-type well 13 (corresponding to portion 13a in Figures 4 and 5) located under the field insulating layer 15 may be used to serve a channel-cut function. In a CMOS structure, for example, this portion (13a) is also effective, as compared with a shallow channel-cut region, to suppress a latch-up phenomenon which is caused by parasitic pnpn elements inevitably formed in a CMOS device and which is detrimental to normal operation. This is because the portion (13a) is effective to reduce resistivity at deeper portions of the substrate 11. Parasitic pnpn elements may possibly be triggered to latch-up by a noise pulse when conditions for conduction of the pnpn elements are satisfied. One important factor amongst such conditions is the presence of a sufficiently large voltage drop across a parasitic resistor inside the substrate to forward bias a neighboring pn junction. The lower resistivity of deeper portions of substrate afforded by the well portion (13a) is effective to reduce such voltage drop inside the substrate.

A method of fabricating a device in accordance with the present invention will now be described.

Figure 6, A to G, illustrates schematically steps in the fabrication of a device of a CMOS IC in accordance with an embodiment of the present invention. The elementary processes used, such as etching, insulating layer formation, aluminium sputtering, photo-lithographic technology etc., are known in the art. Therefore, detailed description of these processes will be omitted.

Figure 6A illustrates the fabrication of a silicon nitride film.

Using a conventional process such as thermal oxidation, a thin oxide film 31,500 A° thick, is formed on an n-type silicon substrate 11 having an impurity concentration of $5 \times 10^{14}$ (atm/cm³). Subsequently, a silicon nitride ($Si_3N_4$) film about 0.1 μm thick is deposited by chemical vapour deposition (CVD) on the thermal oxide film 31. By patterning the silicon nitride ($Si_3N_4$) film by dry etching, silicon nitride ($Si_3N_4$) film patterns 32a and 32b are selectively formed at portions corresponding to areas in which an n-MOS FET and a p-MOS FET respectively are prospectively to be formed.

Figure 6b illustrates a step for fabricating a boron doped region for providing a p-type well.

A first resist mask 33, having an opening corresponding to the prospective area of formation of the p-type well region, is formed by a photo-lithographic method. Subsequently, boron (B) is selectively ion-implanted into the opening (into the substrate through the opening) through the thin oxide film 31 and the silicon nitride ($Si_3N_4$) film pattern 32a, with a doping density in the range of approximately $10^{13}$ (atm/cm²) and an acceleration voltage of 160 (keV). In the Figure, $B^+$ designates boron ions, and SB designates a boron ion-implanted region. 34 designates the p-type well region.

Figure 6C illustrates a step for fabricating a phosphorus doped region for providing a n-type well.

The first resist mask 33 is removed by ashing. Subsequently, a second resist mask 37 is formed on the substrate. The mask 37 covers the p-type well region 34, a region 35 in which a drain region of a p-MOS FET is to be formed and a region 36 in which a source region of the p-MOS FET is to be formed. (That is, the second resist mask 37 is open in correspondence to the prospective areas of formation of a gate electrode — of the p-MOS FET — and a field oxide layer). Phosphorus ions ($P^+$) are selectively implanted into the silicon substrate 11 through thin oxide film 31 and silicon nitride ($Si_3N_4$) film pattern 32b, with a doping density approximately in the range of $5 \times 10^{12}$ (atm/cm²) and an acceleration voltage of 180 (keV). This corresponds to a dose rate slightly higher than that used for the previously-proposed twin-tub structure. As a result, phosphorus ions ($P^+$) are selectively implanted into portions which will lay under the gate electrode of the p-MOS FET and a field isolation region for the p-MOS FET on the substrate 11. In the Figure, $p^+$ designates phosphorus ions and SP designates phosphorus ion-implanted regions.

Figure 6D illustrates an annealing process for providing a p-type well and an n-type well.

The second resist mask 37 is removed by ashing. Subsequently, for example, annealing is performed in a nitrogen atmosphere at a temperature of 1200°C for 180 minutes to form p-type well region 12 and n-type well region 13a and 13b. The implanted (boron and phosphorus) ions ($B^+$, $P^+$) are diffused into the substrate by the annealing process, and a p-type well region 12 and an n-type well region 13a and 13b having depths in the range of 3μm to 4μm are formed. The n-type well region 13a and 13b is formed in portions which will lay beneath the gate electrode 17b and field electrode film 15 of the p-MOS FET, but at least in portions which will lay beneath the drain and source regions no well region is formed. The n-type region 13b which will lay under the gate electrode 17b and the n-type region which will lay under the field oxide layer 15 may expand to form an $n_1^-$ region ($n_a^-$, $n_b^-$) by diffusion in the annealing process. This corresponds to the case of Figure 3 or Figure 5, but such $n_1^-$ ($n_a^-$, $n_b^-$) regions have an impurity concentration lower than the n-type well regions.

Figure 6E illustrates a step for forming a boron doped region for providing a p-type channel-cut region. The surface of the p-type well region 12 (surface of silicon nitride film pattern 32a and oxide film 31) is exposed. A third resist mask 38 is formed in correspondence to the opening of the p-type well region 12. Subsequently, boron (B) is selectively ion-implanted into the p-type well region 12 through thin oxide film 31 using the silicon nitride ($Si_3N_4$) film pattern 32a as a mask, with the doping density of boron approximately in the range of $5 \times 10^{13}$ (atm/cm²). In the Figure, $B^+$ designates boron ions, and SB designates boron ion-implanted regions.

Figure 6F illustrates a step for fabricating a field oxide layer. The resist mask 38 is removed by ashing. Subsequently, field oxide layer 15 is formed on the substrate 11 at portions uncovered by the nitride ($Si_3N_4$) film patterns 32a and 32b, by a thermal oxidation method. The boron (B) ion-implanted region SB of Figure 6E becomes a p-type channel-cut region 14. For the p-channel device, the n-type well region 13a can serve the channel-cut function because it may have a high impurity concentration as compared to p-type well region 12. In this case, it is not necessary to form a further or special channel-cut region with a high impurity concentration on the surface of the n-type well 13a.

Figure 6G illustrates the fabrication of gate electrodes, and drain and source regions. The silicon nitride (Si₃N₄) film patterns 32a, 32b and thin oxide film 31 are removed by ashing. Subsequently, gate oxide layers 16a and 16b are formed newly on the surfaces of the p-MOS FET region and the n-MOS FET region by thermal oxidation. This step is followed by the formation of a polycrystalline silicon layer having a thickness in the range of 4000 Å to 5000 Å. This layer is formed by chemical vapour deposition (CVD) and is heavily doped with n-type dopant by gas diffusion or ion-implantation. The resultant $n^+$-type polycrystalline silicon layer is etched to form silicon gate electrodes 17a and 17b. The silicon gate pattern is formed using photolithographic technology utilizing reactive-ion etching. The p-MOS region is covered with the fourth resist mask (not shown), and arsenic ions (As⁺) are implanted with a high dose in the n-MOS region using the gate electrode 17a as a mask. The fourth resist mask is removed by ashing, the n-MOS region is covered with the fifth resist mask (not shown) and boron ions (B⁺) are implanted with a high dose in the p-MOS region by using the gate electrode 17b as a mask.

Next, the fifth resist mask (not shown) is removed by ashing. Subsequently, annealing is performed to activate the implanted arsenic (As) and boron (B) dopants. As a result, the $p^+$-type drain region 18a, the $p^+$-type source region 18b, the $n^+$-type drain region 19a, and the $n^+$-type source region 19b are formed respectively.

Finally, (not shown in the Figure) parts of the gate oxide layers 16a and 16b which are uncovered by the gate electrodes 17a and 17b are removed by ashing. Subsequently, the formation of an oxide film for surface protection, the formation of contact windows, and the formation of wiring, are performed. The entire surface of the substrate is coated with a phospho-silicate glass (PSG) insulating layer.

As described above, the provision of a CMOS IC in which an embodiment of the present invention is applied does not require any additional IC fabrication processes.

According to an embodiment of the present invention, an n-type well region is formed under the gate electrode of a p-channel MOS FET. The n-type well region is a deeper diffusion region than the source and the drain regions. The n-type well region has a high impurity concentration as compared to the substrate. Therefore, the punch-through effect is prevented from occurring between the source region and the drain region. The channel length of the p-channel MOS FET can be reduced. As a result, the junction capacitance of the source and the drain becomes smaller, as compared to a previously proposed twin-tub structure.

Moreover, the impurity concentration of the n-type well region may be higher than that afforded in the previously proposed twin-tub method, and the n-type well region under the field oxide layer can be used as a channel-cut region. This avoids the need for additional fabrication processes for channel-cut region of high impurity concentration.

Although the above description relates primarily to the application of the present invention in CMOS IC's, it will be clear that many other possibilities arise for application of the present invention. For example, the present invention can be applied to n-MIS ICs or p-MIS ICs.

It will also be understood that, although the above description has been given with regard to substrates of one (n) conductivity type, embodiments of the present invention can be applied with substrates of the other conductivity type.

**Claims**

1. A semiconductor device comprising a semiconductor substrate (11) of one conductivity type generally with a relatively low impurity concentration, a well region (13; 13a, 13b), of the said one conductivity type, formed in the substrate (11), with a relatively high impurity concentration, and an MIS FET (P—MOS), of a channel conduction type opposite to the substrate conductivity type, formed on the well region (13; 13a, 13b), isolated by a field insulating layer (15), the well region (13; 13a, 13b) extending under the field insulating layer (15) to provide a channel cut function and extending beneath a gate of the MIS FET, characterised in that the well region (13; 13a, 13b) does not extend beneath at least a part of at least the drain region (18a) of source (18b) and drain (18a) regions of the MIS FET.

2. A device as claimed in claim 1, wherein beneath the drain region (18a), in direct contact therewith, there is a portion of the substrate (11) of the said relatively low impurity concentration.

3. A device as claimed in claim 1, wherein, beneath the drain region (18a), in contact therewith, there is a lateral diffusion region, formed in the substrate (11) by lateral diffusion of impurity from the well region (13; 13a, 13b), of a lower impurity concentration than the well region.

4. A device as claimed including 1, 2 or 3, wherein the well region (13; 13a, 13b) is formed so as not to extend under at least a part of the source region (18b) of the MIS FET.

5. A device as claimed including 4 when read as appended to claim 2, wherein, beneath the source region (18b), in direct contact therewith, there is a portion of the substrate (11) of the said relatively low impurity concentration.

6. A device as claimed in claim 4 when read as appended to claim 3, wherein, beneath the source region (18b), in contact therewith, there is a further lateral diffusion region, formed in the substrate (11) by lateral diffusion of impurity from the well region (13; 13a, 13b), of a lower impurity concentration than the well region.

7. A CMOS IC comprising a device as claimed in any preceding claim.

**Patentansprüche**

1. Halbleitervorrichtung mit einem Halbleitersubstrat (11) von einem Leitfähigkeitstyp, allgemein mit einer relativ niedrigen Verunreinigungskonzentration, einem Muldenbereich (13; 13a, 13b), von demselben Leitfähigkeitstyp, der in dem Substrat (11) gebildet ist, mit einer relativ hohen Verunreinigungskonzentration, und einem MIS—FET (P—MOS), von einem Kanalleitfähigkeitstyp, der zu dem Leitfähigkeitstyp des Substrats entgegengesetzt ist, auf dem Muldenbereich (13; 13a, 13b) gebildet ist, durch eine feldisolierende Schicht (15) isoliert ist, welcher Muldenbereich (13; 13a, 13b) sich unter der feldisolierende Schicht (15) erstreckt, um eine Kanalschnittfunktion vorzusehen, und sich unter einem Gate des MIS—FET erstreckt, dadurch gekennzeichnet, daß der Muldenbereich (13; 13a, 13b) sich nicht unterhalb wenigstens einem Teil von wenigstens dem Drainbereich (18a) der Source- (18b) und Drainbereiche (18a) des MIS—FET erstreckt.

2. Vorrichtung nach Anspruch 1, bei der es unterhalb des Drainbereichs (18a), in direktem Kontakt damit, einen Abschnitt des Substrats (11) von der genannten relativ niedrigen Verunreinigungskonzentration gibt.

3. Vorrichtung nach Anspruch 1, bei der es unterhalb des Drainbereichs (18), in Kontakt damit, einen seitlichen Diffusionsbereich gibt, der in dem Substrat (11) durch seitliche Diffusion von Verunreinigung von dem Muldenbereich (13; 13a, 13b) gebildet ist, von einer niedrigeren Verunreinigungskonzentration als der Muldenbereich.

4. Vorrichtung nach Anspruch 1, 2 oder 3, bei der der Muldenbereich (13; 13a, 13b) so gebildet ist, daß er sich nicht unter wenigstens einem Teil des Sourcebereichs (18b) des MIS—FET erstreckt.

5. Vorrichtung nach Anspruch 4, in Verbindung mit Anspruch 2, bei der es, unterhalb des Sourcebereichs (18b), in direktem Kontakt damit, einen Abschnitt des Substrats (11) von der genannten relativ niedrigen Verureinigungskonzentration gibt.

6. Vorrichtung nach Anspruch 4 in Verbindung mit Anspruch 3, bei der es, unterhalb des Sourcebereichs (18b), in Kontakt damit, einen weiteren seitlichen Diffusionsbereich gibt, der in dem Substrat (11) durch seitliche Diffusion von Verunreinigung von dem Muldenbereich (13; 13a, 13b) gebildet ist, von einer niedrigeren Verunreinigungskonzentration als der Muldenbereich.

7. Eine CMOS—IC mit einer Vorrichtung nach einem der vorhergehenden Ansprüche.

**Revendications**

1. Dispositif semi-conducteur comportant un substrat semi-conducteur (11) d'un type de conductivité, généralement avec une concentration d'impureté relativement faible, une région de puits (13; 13a, 13b) dudit type de conductivité, formée dans le substrat (11) avec une concentration d'impureté relativement élévée et un FET MIS (MOS—P) d'un type de conduction de canal opposé au type de conductivité du substrat, formé dans la région de puits (13; 13a, 13b) isolée par une couche d'isolement de champ (15), la région de puits (13; 13a, 13b) s'étendant au-dessous de la couche d'isolement de champ (15) pour remplir une fonction de coupure de canal et s'étendant au-dessous d'une grille du FET MIS, caractérisé en ce que la région de puits (13; 13a, 13b) ne s'étend pas au-dessous d'au moins une partie d'au moins la région de drain (18) des régions de source (18b) et de drain (18a) du FET MIS.

2. Dispositif selon la revendication 1, dans lequel, au-dessous de la région de drain (18a), en contact direct avec elle, se trouve une partie du substrat (11) de ladite concentration d'impurité relativement faible.

3. Dispositif selon la revendication 1, dans lequel, au-dessous de la région de drain (18a), en contact avec elle, se trouve une région de diffusion latérale, formée dans le substrat (11) par diffusion latéärale d'une impureté à partir de la région de puits (13; 13a, 13b) d'une plus faible concentration d'impureté que la région de puits.

4. Dispositif selon la revendication 1, 2 ou 3, dans lequel la région de puits (13; 13a, 13b) est formée de manière à ne pas s'étendre au-dessous d'au moins une partie de la région de source (18b) du FET MIS.

5. Dispositif selon la revendication 4, dépendant de la revendication 2, dans lequel, au-dessous de la région de source (18b) en contact direct avec elle, se trouve une partie du substrat (11) de ladite concentration d'impureté relativement faible.

6. Dispositif selon la revendication 4, dépendant de la revendication 3, dans lequel, au-dessous de la région de source (18b), en contact avec elle se trouve une autre région de diffusion latérale formée dans le substrat (11) par diffusion latérale d'une impureté à partir de la région de puits (13; 13a, 13b) d'une concentration d'impureté inférieure à celle de la région de puits.

7. IC CMOS comportant un dispositif tel que revendiqué dans l'une quelconque des revendications précédentes.

FIG. 1

FIG. 2

FIG. 3

# FIG. 4

n- MOS          P - MOS

# FIG. 5

n- MOS          p - MOS

2

# FIG. 6

## A

32a    32b

31

11

## B

$B^+$    $B^+$

33    32a    52b    33

SB    31

11

## C

$P^+$    $P^+$

37    32a    37    37

34    SB    35    SP    36    32b    31

SP    SP    11

## D

32a    32b

31

12    13a    13b    13a

11

# FIG. 6

E

F

G